# EUROPÄISCHE PATENTANMELDUNG

(11) **EP 2 862 652 A1**
(43) Veröffentlichungstag der Anmeldung: **22.04.2015**
(21) Anmeldenummer: 13188726.7
(22) Anmeldetag: 15.10.2013
(51) Int. Cl.: B22F 3/105, B29C 67/00, H01J 37/305, H01J 37/20

(54) **Elektronenstrahlschmelzverfahren sowie Elektronenstrahlanordnung**

(71) Anmelder: Siemens Aktiengesellschaft, 80333 München (DE)
(72) Erfinder: Burbaum, Bernd, 14612 Falkensee (DE)

(57) **Zusammenfassung**

Die Erfindung betrifft ein Elektronenstrahlschmelzverfahren zur schichtweisen Herstellung eines dreidimensionalen Bauteils (17), das die Schritte aufweist: a) Auftragen einer ersten Pulverlage (18) auf eine Trägerplatte (3), wobei die Pulverlage (18) Nickel-Basislegierungs-Pulverpartikel und Flussmittel-Pulverpartikel aufweist, b) zumindest teilweises Vorsintern der ersten Pulverlage (18), c) selektives Umschmelzen der aufgetragenen ersten Pulverlage (18) unter Verwendung eines Elektronenstrahls (6), d) zumindest teilweises Entfernen von auf umgeschmolzenen Pulverlagenbereichen verbliebenem Flussmittel, e) Auftragen einer weiteren Pulverlage (19) auf die zuvor aufgetragene, teilweise umgeschmolzene Pulverlage (18), wobei die weitere Pulverlage (19) Nickel-Basislegierungs-Pulverpartikel und Flussmittel-Pulverpartikel aufweist, f) zumindest teilweises Vorsintern der weiteren Pulverlage (19), g) selektives Umschmelzen der weiteren aufgetragenen Pulverlage (19) unter Verwendung eines Elektronenstrahls (6), und h) zumindest teilweises Entfernen von auf umgeschmolzenen Pulverlagenbereichen verbliebenem Flussmittel, wobei die Schritte e) bis h) wiederholt werden, bis das Bauteil (17) fertig gestellt ist. Ferner betrifft die Erfindung die Verwendung einer Mischung aus Nickel-Basislegierungs-Pulverpartikeln und Flussmittel-Pulverpartikeln bei der Durchführung eines Elektronenstrahlschmelzverfahrens sowie eine zur Durchführung des Verfahrens ausgelegte Elektronenstrahlanordnung (1).

## Beschreibung

Die vorliegende Erfindung betrifft ein Elektronenstrahlschmelzverfahren zur schichtweisen Herstellung eines dreidimensionalen Bauteils sowie eine zur Durchführung des Verfahrens geeignete Elektronenstrahlanordnung.

Das Elektronenstrahlschmelzverfahren, das auch kurz als EBM-Verfahren (Electron Beam Melting) bezeichnet wird, ist im Stand der Technik bekannt. Hierbei handelt es sich um ein generatives Verfahren, bei dem auf einer in einem luftleeren Raum angeordnete Trägerplatte nacheinander Pulverlagen aufgetragen und selektiv unter Verwendung eines Elektronenstrahls umgeschmolzen werden. Hierzu werden Elektronen durch Anlegen einer Spannung im Bereich von 150 kV auf ca. 60% der Lichtgeschwindigkeit beschleunigt, die beim Auftreffen auf die Pulverlage zum lokalen Umschmelzen der entsprechenden Pulverpartikel führen. Um zu verhindern, dass die Pulverpartikel der Pulverlage beim Auftreffen der Elektronen nicht selbst aus dem Pulverbett entfernt werden, werden zumindest die umzuschmelzenden Bereiche jeder aufgetragenen Pulverlage vor dem Umschmelzen vorgesintert.

Ein wesentlicher Vorteil des Elektronenstrahlschmelzverfahrens besteht analog zu anderen generativen Verfahren darin, dass dreidimensionale Bauteile direkt auf Basis von CAD-Daten generiert werden können. Entsprechend wird das Verfahren in erster Linie zur Kleinserien- und Prototypenherstellung eingesetzt. Ein wesentlicher Nachteil des EBM-Verfahrens ist allerdings darin zu sehen, dass derzeit nur eine beschränkte Auswahl an Materialien mit befriedigenden Ergebnissen verarbeitet werden können, wodurch die Einsetzbarkeit des Verfahrens in vielen technischen Gebieten stark eingeschränkt wird. Insbesondere lassen sich mit dem Elektronenstrahlschmelzverfahren derzeit keine Bauteile aus schwer schweißbaren Nickel-Basislegierungen herstellen.

Ausgehend von diesem Stand der Technik ist es eine Aufgabe der vorliegenden Erfindung, ein Elektronenstrahlschmelzverfahren der eingangs genannten Art zu schaffen, mit dem Bauteile aus einer Nickel-Basislegierung generiert werden können.

Zur Lösung dieser Aufgabe schafft die vorliegende Erfindung ein Elektronenstrahlschmelzverfahren zur schichtweisen Herstellung eines dreidimensionalen Bauteils, das die Schritte aufweist:
a) Auftragen einer ersten Pulverlage auf eine Trägerplatte, wobei die Pulverlage Nickel-Basislegierungs-Pulverpartikel und Flussmittel-Pulverpartikel aufweist,
b) zumindest teilweises Vorsintern der ersten Pulverlage,
c) selektives Umschmelzen der aufgetragenen ersten Pulverlage unter Verwendung eines Elektronenstrahls,
d) zumindest teilweises Entfernen von auf umgeschmolzenen Pulverlagenbereichen verbliebenem Flussmittel,
e) Auftragen einer weiteren Pulverlage auf die zuvor aufgetragene, teilweise umgeschmolzene Pulverlage, wobei die Pulverlage Nickel-Basislegierungs-Pulverpartikel und Flussmittel-Pulverpartikel aufweist,
f) zumindest teilweises Vorsintern der weiteren Pulverlage,
g) selektives Umschmelzen der weiteren aufgetragenen Pulverlage unter Verwendung eines Elektronenstrahls, und
h) zumindest teilweises Entfernen von auf umgeschmolzenen Pulverlagenbereichen verbliebenem Flussmittel,
wobei die Schritte e) bis h) wiederholt werden, bis das Bauteil fertig gestellt ist.

Überraschend hat sich herausgestellt, dass Nickel-Basislegierungs-Pulverpartikel unter Einsatz des EBM-Verfahrens mit sehr guten Ergebnissen verarbeitet werden können, wenn den Nickel-Basislegierungs-Pulverpartikeln Pulverpartikel eines Flussmittels zugesetzt werden. Aufgrund der geringeren Dichte schwimmt das Flussmittel während des Umschmelzens auf dem metallischen Schmelzbad auf, so dass es nach dem Umschmelzprozess problemlos entfernt werden kann, bevor eine neue Pulverlage aufgetragen wird. Durch diese Prozessführung ergeben sich kontrollierte Abkühlbedingungen für die Erstarrung der Nickel-Basislegierung. Darüber hinaus sind mit dem erfindungsgemäßen Verfahren kurze Fertigungszyklen realisierbar. Diese sind auf die große Eindringtiefe der Elektronen in die jeweiligen Pulverlagen zurückzuführen, weshalb sich größere Schichtdicken als bei anderen bekannten generativen Verfahren umschmelzen lassen, wie beispielsweise beim selektiven Lasersintern (SLS).

Vorteilhaft beträgt die Differenz zwischen der mittleren Partikelgröße der Nickel-Basislegierungs-Pulverpartikel und der mittleren Partikelgröße der Flussmittel-Pulverpartikel nicht mehr als 25 µm, insbesondere nicht mehr als 20 µm. Dies ist dahingehend von Vorteil, dass sich die Nickel-Basis-Superlegierungs-Partikel und die Flussmittel-Pulverpartikel aufgrund ihrer ähnlichen Korngröße in einem beliebigen Mischungsverhältnis vormischen lassen.

Bevorzugt liegen die mittlere Partikelgröße der Nickel-Basislegierungs-Pulverpartikel und die mittlere Partikelgröße der Flussmittel-Pulverpartikel im Bereich von 20 bis 40 µm. Hiermit wurden besonders gute Fertigungsergebnisse erzielt.

Gemäß einer Variante der vorliegenden Erfindung erfolgt das Vorsintern unter Verwendung eines Elektronenstrahls, der eine geringere Energiedichte als der für das Umschmelzen verwendete Elektronenstrahl aufweist. Entsprechend können das Vorsintern und das Umschmelzen unter Verwendung einer einzelnen Energiequelle durchgeführt werden.

Das Entfernen des Flussmittels in den Schritten d) und h) erfolgt gemäß einer Ausgestaltung der vorliegenden Erfindung unter Verwendung eines Rakels oder einer Bürste.

Die vorliegende Erfindung bezieht sich ferner auf die Verwendung einer Mischung aus Nickel-Basislegierungs-Pulverpartikeln und Flussmittel-Pulverpartikeln bei der Durchführung eines Elektronenstrahlschmelzverfahrens, insbesondere eines Elektronenstrahlschmelzverfahrens der zuvor beschriebenen Art.

Die Differenz zwischen der mittleren Partikelgröße der Nickel-Basislegierungs-Pulverpartikel und der mittleren Partikelgröße der Flussmittel-Pulverpartikel beträgt vorteilhaft nicht mehr als 25 µm, insbesondere nicht mehr als 20 µm.

Die mittlere Partikelgröße der Nickel-Basislegierungs-Pulverpartikel und die mittlere Partikelgröße der Flussmittel-Pulverpartikel liegen bevorzugt im Bereich von 20-40 µm.

Zur Lösung der eingangs genannten Aufgabe schafft die vorliegende Erfindung ferner eine Elektronenstrahlanordnung mit einer evakuierbaren Arbeitskammer, einer innerhalb der Arbeitskammer auf- und abwärts bewegbaren Trägerplatte, einer Elektronenstrahleinrichtung, die eingerichtet ist, um einen Elektronenstrahl auf verschiedene Positionen der Trägerplatte zu richten, und einer Pulverzuführeinrichtung zum Auftragen von Pulverlagen auf die Trägerplatte, wobei die Pulverzuführeinrichtung eine Pulvermischeinrichtung aufweist, die derart ausgebildet ist, dass mit dieser zumindest zwei verschiedene Pulver in einem einstellbaren Verhältnis mischbar sind.

Bevorzugt weist die Pulvermischeinrichtung zumindest zwei Pulverreservoirs auf, denen jeweils ein Pulverförderer zugeordnet ist, wobei die Pulverförderer derart ausgebildet sind, dass sie den Pulverreservoirs vorbestimmte Pulvermengen pro Zeiteinheit kontinuierlich entnehmen und diese zusammenführen, woraufhin das Mischen der Pulver erfolgt.

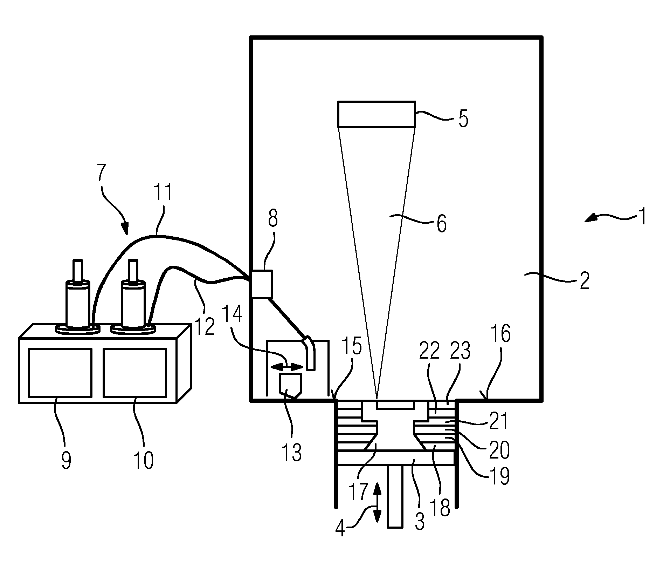

Weitere Merkmale und Vorteile der vorliegenden Erfindung werden anhand der nachfolgenden Beschreibung einer Elektronenstrahlanordnung gemäß einer Ausführungsform der vorliegenden Erfindung unter Bezugnahme auf die beiliegende Zeichnung deutlich, welche die Elektronenstrahlanordnung schematisch darstellt.

Die Elektronenstrahlanordnung 1 umfasst eine evakuierbare Arbeitskammer 2, innerhalb der eine Trägerplatte 3 angeordnet ist, die in Richtung des Pfeils 4 auf- und abwärts bewegbar ist. Ferner umfasst die Elektronenstrahlanordnung 1 eine Elektronenstrahleinrichtung 5, die eingerichtet ist, um einen Elektronenstrahl 6 auf verschiedene Positionen der Trägerplatte 3 zu richten. Die Elektronenstrahleinrichtung 5 weist die hierfür erforderlichen Einzelkomponenten auf, die vorliegend nicht näher dargestellt sind, insbesondere einen Elektronenstrahl-Generator, elektromagnetische Fokussierspulen, elektromagnetische Ablenkespulen, etc. Darüber hinaus umfasst die Elektronenstrahlanordnung 1 eine Pulverzuführeinrichtung 7 zum Auftragen von Pulverlagen auf die Trägerplatte 3, wobei die Pulverzuführeinrichtung 7 eine Pulvermischeinrichtung 8 aufweist, die derart ausgebildet ist, dass mit dieser zumindest zwei verschiedene Pulver in einem einstellbaren Verhältnis mischbar sind. Genauer gesagt weist die Pulvermischeinrichtung 8 vorliegend zwei Pulverreservoirs 9 und 10 auf, denen jeweils ein Pulverförderer 11, 12 zugeordnet ist, wobei die Pulverförderer 11 und 12 derart ausgebildet sind, dass sie den Pulverreservoirs 9 und 10 vorbestimmte Pulvermengen pro Zeiteinheit kontinuierlich entnehmen und diese zusammenführen, woraufhin das Mischen der Pulver in der Pulvermischeinrichtung 8 erfolgt. Zum Verteilen des von der Pulvermischeinrichtung 8 zur Verfügung gestellten Pulvers auf der Trägerplatte 3 ist als Teil der Pulverzuführeinrichtung 7 innerhalb der Arbeitskammer 2 ein Rakel 13 angeordnet, das horizontal in Richtung des Pfeils 14 entlang zweier Arbeitsflächen 15 und 16 hin und her bewegt werden kann, wobei die Arbeitsflächen 15 und 16 auf gleicher Höhe angeordnet sind und die Trägerplatte 3 zwischen sich aufnehmen.

Zur Erzeugung eines dreidimensionalen Bauteils 17 werden in einem ersten Schritt die Pulverreservoirs 9 und 10 gefüllt. Nickel-Basislegierungs-Pulverpartikel werden dabei im Pulverreservoir 9 aufgenommen und Flussmittel-Pulverpartikel im Pulverreservoir 10. Die Differenz zwischen der mittleren Partikelgröße der Nickel-Basislegierungs-Pulverpartikel und der mittleren Partikelgröße der Flussmittel-Pulverpartikel beträgt bevorzugt nicht mehr als 25 µm. vorteilhaft liegen die mittlere Partikelgröße der Nickel-Basislegierungs-Pulverpartikel und die mittlere Partikelgröße der Flussmittel-Pulverpartikel im Bereich von 20 bis 40 µm. In einem weiteren Schritt wird die Arbeitskammer 2 unter Verwendung einer nicht näher dargestellten Vakuumpumpe evakuiert. Daraufhin wird die Trägerplatte 3 in eine obere Position verfahren, in der sie geringfügig unterhalb der Arbeitsflächen 15 und 16 angeordnet ist. Anschließend werden den Pulverreservoirs 9 und 10 Nickel-Basislegierungs-Pulverpartikel und Flussmittel-Pulverpartikel in vorbestimmten Pulvermengen pro Zeiteinheit kontinuierlich über die Pulverförderer 11 und 12 entnommen und der Pulvermischeinrichtung 8 zugeführt, wo sie homogen miteinander vermischt werden. Daraufhin wird eine für die Erzeugung einer Pulverlage erforderliche Pulvermenge von der Pulvermischeinrichtung 8 in die Arbeitskammer 2 eingebracht, auf der Arbeitsfläche 15 angeordnet und unter Verwendung des Rakels 13 mit kontinuierlicher Dicke auf der Trägerplatte 3 verteilt. Nach Auftragen der ersten Pulverlage 18 auf der Trägerplatte 3 wird die Pulverlage 18 vorgesintert und in einem sich anschließenden Schritt selektiv umgeschmolzen. Sowohl das Vorsintern als auch das Umschmelzen erfolgen unter Verwendung des Elektronenstrahls 6, wobei beim Umschmelzen ein Elektronenstrahl mit geringerer Energiedichte als der für das Umschmelzen verwendet wird. Während des Umschmelzens schwimmt das Flussmittel aufgrund seiner geringeren Dichte auf dem metallischen Schmelzbad auf und wird nach dem Umschmelzprozess in einem sich anschließenden Schritt unter Verwendung des Rakels 13 entfernt. Alternativ kann zum Entfernen auch eine Bürste zum Einsatz kommen. Nach dem Entfernen des Flussmittels wird die Trägerplatte 3 um eine Schichtdicke abwärts in Richtung des Pfeils 4 bewegt. Daraufhin wird unter Verwendung der Pulverförderer 11 und 12, der Pulvermischeinrichtung 8 und des Rakels 13 eine weitere Pulverlage 19 auf die zuvor aufgetragene, teilweise umgeschmolzene Pulverlage 19 aufgetragen. Auch die weitere Pulverlage 19 wird analog zur ersten Pulverlage 8 selektiv vorgesintert und anschließend selektiv umgeschmolzen, woraufhin erneut das Flussmittel von den umgeschmolzenen Bereichen der Pulverlage entfernt wird. Das Auftragen, Vorsintern und Umschmelzen weiterer Pulverlagen 20 bis 23 mit dem sich jeweils anschließenden Entfernen des Flussmittels werden dann wiederholt, bis das Bauteil 17 fertiggestellt ist.

Ein wesentlicher Vorteil des erfindungsgemäßen Verfahrens sowie der erfindungsgemäßen Elektronenstrahlanordnung 1 besteht darin, dass mit diesen Bauteile aus Nickel-Basislegierungen hergestellt werden können. Ein weiterer Vorteil besteht in den verglichen mit anderen bekannten generativen Verfahren kurzen Fertigungszyklen, die Dank der großen Eindringtiefe der Elektronen in die jeweiligen Pulverlagen realisierbar sind.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronenstrahlschmelzverfahren zur schichtweisen Herstellung eines dreidimensionalen Bauteils (17), das die Schritte aufweist:
a) Auftragen einer ersten Pulverlage (18) auf eine Trägerplatte (3), wobei die Pulverlage (18) Nickel-Basislegierungs-Pulverpartikel und Flussmittel-Pulverpartikel aufweist,
b) zumindest teilweises Vorsintern der ersten Pulverlage (18),
c) selektives Umschmelzen der aufgetragenen ersten Pulverlage (18) unter Verwendung eines Elektronenstrahls (6),
d) zumindest teilweises Entfernen von auf umgeschmolzenen Pulverlagenbereichen verbliebenem Flussmittel,
e) Auftragen einer weiteren Pulverlage (19) auf die zuvor aufgetragene, teilweise umgeschmolzene Pulverlage (18), wobei die weitere Pulverlage (19) Nickel-Basislegierungs-Pulverpartikel und Flussmittel-Pulverpartikel aufweist,
f) zumindest teilweises Vorsintern der weiteren Pulverlage (19),
g) selektives Umschmelzen der weiteren aufgetragenen Pulverlage (19) unter Verwendung eines Elektronenstrahls (6), und
h) zumindest teilweises Entfernen von auf umgeschmolzenen Pulverlagenbereichen verbliebenem Flussmittel,
wobei die Schritte e) bis h) wiederholt werden, bis das Bauteil (17) fertig gestellt ist.

2. Elektronenstrahlschmelzverfahren nach Anspruch 1, **dadurch gekennzeichnet, dass** die Differenz zwischen der mittleren Partikelgröße der Nickel-Basislegierungs-Pulverpartikel und der mittleren Partikelgröße der Flussmittel-Pulverpartikel nicht mehr als 25 µm beträgt, insbesondere nicht mehr als 20 µm.

3. Elektronenstrahlschmelzverfahren nach Anspruch 2, **dadurch gekennzeichnet, dass** die mittlere Partikelgröße der Nickel-Basislegierungs-Pulverpartikel und die mittlere Partikelgröße der Flussmittel-Pulverpartikel im Bereich von 20-40 µm liegen.

4. Elektronenstrahlschmelzverfahren nach einem der vorhergehenden Ansprüche, **dadurch gekennzeichnet, dass** das Vorsintern unter Verwendung eines Elektronenstrahls erfolgt, der eine geringere Energiedichte als der für das Umschmelzen verwendete Elektronenstrahl aufweist.

5. Elektronenstrahlschmelzverfahren nach einem der vorhergehenden Ansprüche, **dadurch gekennzeichnet, dass** das Entfernen des Flussmittels in den Schritten d) und h) unter Verwendung eines Rakels (13) oder einer Bürste erfolgt.

6. Verwendung einer Mischung aus Nickel-Basislegierungs-Pulverpartikeln und Flussmittel-Pulverpartikeln bei der Durchführung eines Elektronenstrahlschmelzverfahrens, insbesondere nach einem der vorhergehenden Ansprüche.

7. Verwendung nach Anspruch 6, **dadurch gekennzeichnet, dass** die Differenz zwischen der mittleren Partikelgröße der Nickel-Basislegierungs-Pulverpartikel und der mittleren Partikelgröße der Flussmittel-Pulverpartikel nicht mehr als 25 µm beträgt, insbesondere nicht mehr als 20 µm.

8. Verwendung nach Anspruch 7, **dadurch gekennzeichnet, dass** die mittlere Partikelgröße der Nickel-Basislegierungs-Pulverpartikel und die mittlere Partikelgröße der Flussmittel-Pulverpartikel im Bereich von 20-40 µm liegen.

9. Elektronenstrahlanordnung (1) mit einer evakuierbaren Arbeitskammer (2), einer innerhalb der Arbeitskammer (2) auf- und abwärts bewegbaren Trägerplatte (3), einer Elektronenstrahleinrichtung (5), die eingerichtet ist, um einen Elektronenstrahl (6) auf verschiedene Positionen der Trägerplatte (3) zu richten, und einer Pulverzuführeinrichtung (7) zum Auftragen von Pulverlagen (18, 19, 20, 21, 22, 23) auf die Trägerplatte (3), wobei die Pulverzuführeinrichtung (7) eine Pulvermischeinrichtung (8) aufweist, die derart ausgebildet ist, dass mit dieser zumindest zwei verschiedene Pulver in einem einstellbaren Verhältnis mischbar sind.

10. Elektronenstrahlanordnung (1) nach Anspruch 9, **dadurch gekennzeichnet, dass** die Pulvermischeinrichtung (8) zumindest zwei Pulverreservoirs (9, 10) aufweist, denen jeweils ein Pulverförderer (11, 12) zugeordnet ist, wobei die Pulverförderer (11, 12) derart ausgebildet sind, dass sie den Pulverreservoirs (9, 10) vorbestimmte Pulvermengen pro Zeiteinheit kontinuierlich entnehmen und diese zusammenführen, woraufhin das Mischen der Pulver erfolgt.
